(19) Europäisches Patentamt

European Patent Office

Office européen des brevets

(11) EP 2 315 068 A1

(12) **EUROPEAN PATENT APPLICATION**

(43) Date of publication:
27.04.2011 Bulletin 2011/17

(21) Application number: 10186666.3

(22) Date of filing: 06.10.2010

(51) Int Cl.:
$G02B\ 27/09^{(2006.01)}$          $F21V\ 5/04^{(2006.01)}$
$H01L\ 33/58^{(2010.01)}$          $G02B\ 3/02^{(2006.01)}$

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **22.10.2009 CN 200910308616**

(71) Applicant: **Foxsemicon Integrated Technology,
Inc.
Taiwan 350 (TW)**

(72) Inventor: **Chen, Tien-Pao
350, Miao-Li Hsien (TW)**

(74) Representative: **Wilson, Peter
Murgitroyd & Company
165-169 Scotland Street
Glasgow G5 8PL (GB)**

(54) **Optical Lens**

(57) An optical lens (10) includes a rectangular body (100) with a first surface (110) at one end (11) and a second surface (120) at the other end (12). The first surface has a conical cavity (111) defined therein. Light from a light source (101) passes through a side surface (1112) of the conical cavity, as a light incident surface of the optical lens, and emits. The second surface, as a light emitting surface of the optical lens, is an asymmetric saddle-shaped aspheric surface, as viewed from a cross section cut through an optical axis ($O_1$) of the light source. The side surface (1112) of the conical cavity (111) and the second surface (120) cooperatively adjust the light from the light source (101) to have a rectangular pattern.

FIG. 1

**Description**

**BACKGROUND**

1. Technical Field

The disclosure relates to a lens, and particularly to an optical lens for adjusting a light field.

2. Description of the Related Art

Light emitting diodes' (LEDs) many advantages, such as high luminosity, low operational voltage, low power consumption, compatibility with integrated circuits, easy driving, long term reliability, and environmental friendliness have promoted their wide use as a light source. Light emitting diodes are commonly applied in lighting.

However, a key issue of LED optical systems is effective light distribution. Most LED lighting sources form circular light fields. To save energy and provide larger areas of illumination, such as for a street light, a rectangular light field is preferred.

What is needed therefore is an optical lens to overcome the described limitations.

Many aspects of the present optical lens can be better understood with reference to the following drawings. The components in the drawings are not necessarily drawn to scale, the emphasis instead being placed upon clearly illustrating the principles of the present illumination device. Moreover, in the drawing, like reference numerals designate corresponding parts throughout the several views.

FIG. 1 is a schematic view of structure of an optical lens of a first embodiment.

FIG. 2 is a cross-section of an optical lens of the FIG. 1 taken along line II - II line thereof.

FIG. 3 is a cross-section of an optical lens of the FIG. 1 taken along line III - III line thereof.

FIG. 4 is a schematic view of a distribution curve of luminous intensity of the light field formed by the optical lens of FIG. 1.

FIG. 5 is a simulated diagram of illuminance of the light field formed by the optical lens of FIG. 1.

Embodiments of a lens are described in detail here with reference to the drawings.

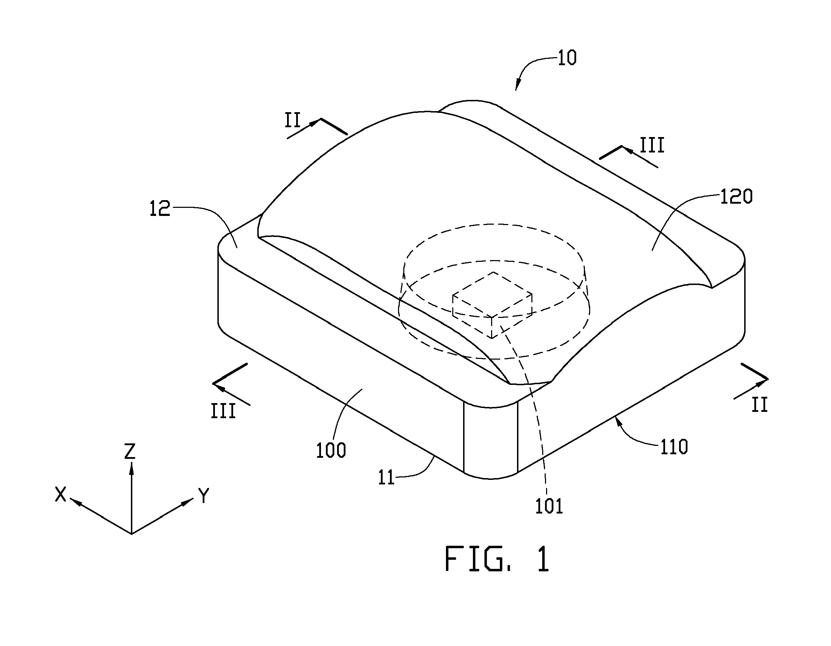

Referring to FIG. 1, an optical lens 10 in accordance with a first embodiment includes a rectangular body 100 having a rectangular shape; the rectangular body 100 includes a first end 11 and a second end 12 opposite to the first end 11. The rectangular body 100 includes a first surface 110 on the first end 11 and a second surface 120 on the second end 12.

The optical lens 10 adjusts light from a light source 101 to form a rectangular light field. The light source 101 is a light emitting diode (LED) in this embodiment.

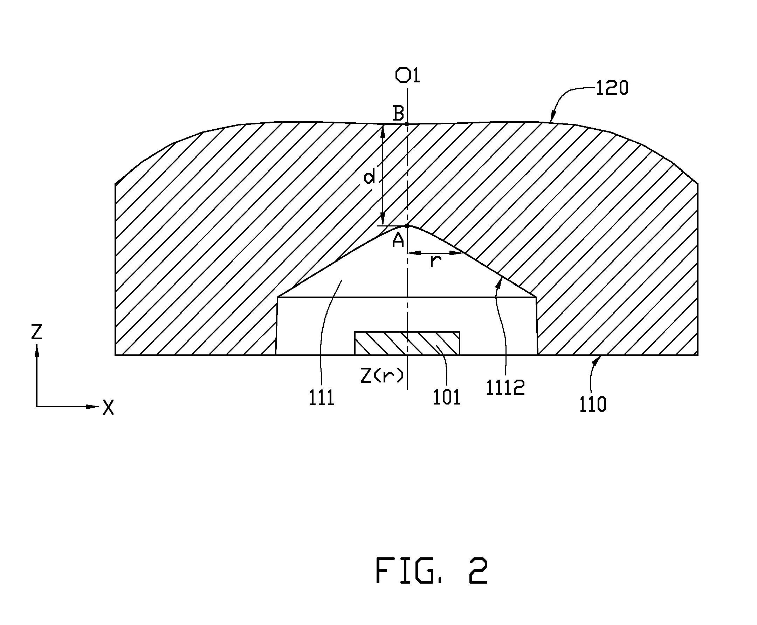

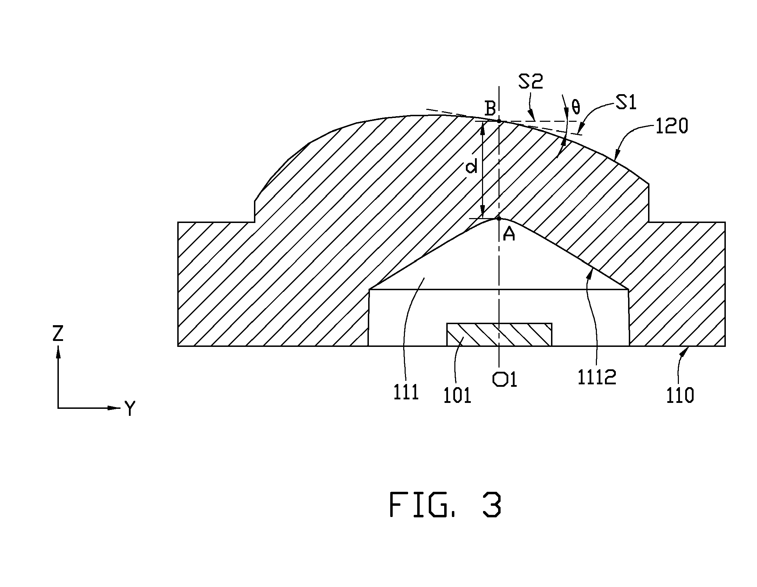

Referring to FIG. 2 and FIG. 3, a conical cavity 111 is arranged on the first surface 110, containing the light source 101. Light from the light source 101 passes through the side surface 1112 of the conical cavity 111 to the rectangular body 100. The side surface 1112 of the conical cavity 111 is the light incident surface of the optical lens 10.

The side surface 1112 of the conical cavity 111 fits a formula 1:

$$z = \frac{cr^2}{1 + \sqrt{1 - (1+k)c^2 r^2}} \qquad (1)$$

wherein r is a radius of the side surface 1112 of the conical cavity 111 related to of an optical axis $O_1$ of the light source 101, z is a sagitta value of a point of the side surface 1112 of the conical cavity 111 wherein the radius is r and z is a function of r, c is a curvature coefficient of the side surface 1112 of the conical cavity 111, and k is a cone coefficient of the side surface 1112 of the conical cavity 111. Origin A of the side surface 1112 of the conical cavity 111 is located at the center apex of the side surface 1112 of the conical cavity 111, which is located at the of the optical axis $O_1$.

The side surface 1112 of the conical cavity 111 can be a conical curve plane. The focal length F fits a formula 2:

$$F = \frac{1}{(N-1)c} \qquad (2)$$

wherein N is a refractive index of the optical lens 10; and c is the curvature coefficient of the side surface 1112 of the conical cavity 111.

From formula 2, the focal length F of the side surface 1112 of the conical cavity 111 is related to the curvature coefficient c and the refractive index N of the optical lens 10. Usually, $-50 < F < -0.5$. In this embodiment, the optical lens 10 is made of PMMA (polymethyl methacrylate) which is 1.49 in refractive index N. The optical lens 10 can also be made of PC (Polycarbonate), silicone, resin, optical glass or other optical lens material.

The second surface 120 is an asymmetric saddle-shaped aspheric surface. The light entering the rectangular body 100 of the optical lens 10 passes through the second surface 120 and emits. The second surface 120 is the light emitting surface of the optical lens 10.

The second surface 120 fits a formula 3 of:

$$ z = \gamma_1 x^2 + \gamma_2 x^4 + \gamma_3 x^6 + \gamma_4 x^8 + \gamma_5 y^2 + \gamma_6 y^4 + \gamma_7 y^6 + \gamma_8 x^8 \quad (3) $$

wherein $\gamma_1$ to $\gamma_8$ are aspheric surface coefficients of the second surface 120. Here, $\gamma_1$, $\gamma_2$, $\gamma_5$ and $\gamma_6$ are the key coefficients. $\gamma_1$, $\gamma_2$, $\gamma_5$ and define $\gamma_6$ the main surface shape of the second surface 120. The others are correction factors of the surface shape of the second surface 120. The origin B (center of curved plane) of the second surface 120 is located at the optical axis $O_1$ of the light source 101. Referring to FIG. 2, on the plane XZ passing through the origin B, the second surface 120 at two sides of the optical axis $O_1$ is symmetric.

In this embodiment, $-0.1 < \gamma_1 < 0.1$, $-0.1 < \gamma_5 < 0.1$, $-0.01 < \gamma_2 < 0.01$, $-0.01 < \gamma_6 < 0.01$. Referring to FIG. 3, on the plane YZ passing through the origin B, the second surface 120 at two sides of the optical axis $O_1$ is asymmetric. An included angle $\theta$ is between the tangent plane S1 passing through the origin B of the second surface 120 and the plane S2 perpendicular to the optical axis $O_1$ passing through the origin B. Preferably, $0° < \theta \leqq 10°$.

The vertical distance d between the origin A of the side surface 1112 of the conical cavity 111 and the origin B of the second surface 120 on the axis Z is defined as a thickness of the optical lens 10. In this embodiment, d is equal to 4mm.

The side surface 1112 of the conical cavity 111 of the optical lens 10 and the second surface 120 respectively fit formulae 1 and 3. The light from the light source 101 in the conical cavity 111 can be adjusted. The light from the light source 101 enters the rectangular body 100 of the optical lens 10. Due to the shape of the side surface 1112 of the conical cavity 111, light passing through the side surface 1112 of the conical cavity 111 reaches a predetermined location of the second surface 120. Therefore, the light reaches a predetermined optical distribution and forms a rectangular light field. In this embodiment, the parameters of the side surface 1112 of the conical cavity 111 and the second surface 120 are listed in Table 1.

Table 1

| unit/mm | |
|---|---|
| Parameter | Operational Value |
| 1/c | -1.472524 |
| k | -3.886628 |
| $\gamma_1$ | 1.8422E-03 ($1.8422 \times 10^{-3}$) |
| $\gamma_2$ | 3.4516E-04 ($3.4516 \times 10^{-4}$) |
| $\gamma_3$ | 4.2832E-07 ($4.2832 \times 10^{-7}$) |

**EP 2 315 068 A1**

(continued)

| unit/mm | |
|---|---|
| Parameter | Operational Value |
| $\gamma_4$ | 1.3530E-09 (1.3530x10$^{-9}$) |
| $\gamma_5$ | -6.7515E-02 (-67515x10$^{-2}$) |
| $\gamma_6$ | 5.7794E-04 (5.7794x10$^{-4}$) |
| $\gamma_7$ | -1.3900E-05 (-1.3900x10$^{-5}$) |
| $\gamma_8$ | -4.9534E-08 (-4.9534x10$^{-8}$) |

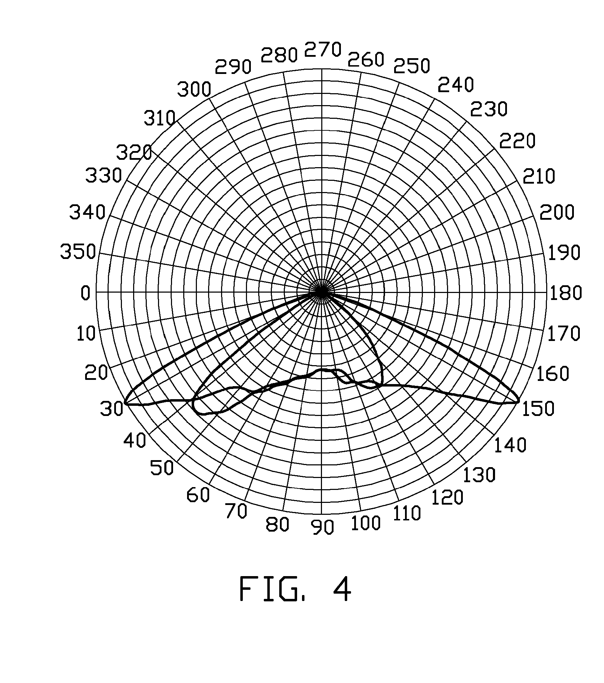

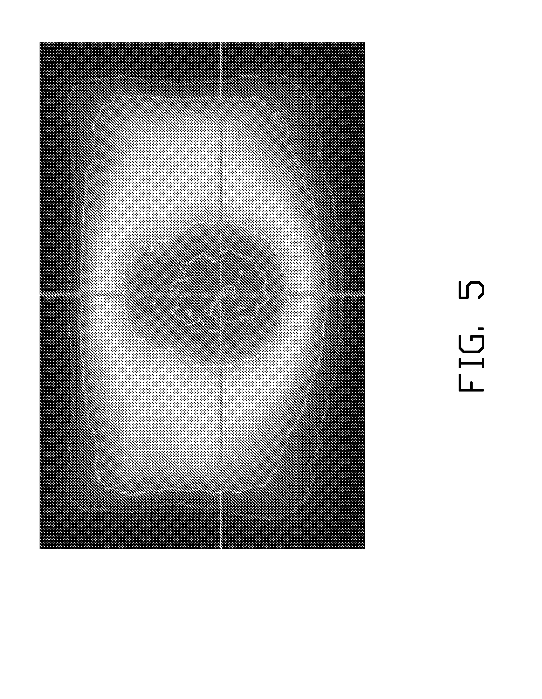

The optical lens 10 with the parameters in Table 1 forms a distribution curve of luminous intensity (candela, cd) in FIG. 4 and a distribution curve of illuminance in the FIG. 5. Referring to FIG. 4, the inner circle is a luminous intensity distribution on axis Y of the plane XY, and the outer circle is a luminous intensity distribution on axis X of the plane XY. Therefore, the optical lens 10 adjusts the light from the light source 101 to form a rectangular light field.

Referring to FIG. 4, light passing through the optical lens 10 forms a radiation angle exceeding $\pm$ 60˚ on axis X of the plane XY and an efficient luminous intensity distribution on the plane XY.

Referring to FIG. 5, light passing through the optical lens 10 forms a more uniform luminous intensity distribution on the plane XY. Thus, the luminous intensity gradually and uniformly decreases from the center to surroundings.

While certain embodiments have been described and exemplified, various other embodiments from the foregoing disclosure will be apparent to those skilled in the art. The disclosure is not limited to the particular embodiments described and exemplified but is capable of considerable variation and modification without departure from the scope of the appended claims.

**Claims**

1. A light device comprising:

    an optical lens comprising: a rectangular body comprising two opposite ends with a first surface on one end and a second surface on the other end, a conical cavity defined in the first surface, a side surface of the conical cavity functioning as a light incident surface; and
    a light source received in the first surface, light from the light source passing through the side surface of the conical cavity into the rectangular body;
    wherein the second surface which functions as a light emitting surface for the light leaving the optical lens is an asymmetric saddle-shaped aspheric surface in respect to an optical axis of the light source as viewed from a first cross section of the optical lens cut through the optical axis of the light source.

2. The light device of claim 1, wherein the first surface satisfies a formula:

$$z = \frac{cr^2}{1 + \sqrt{1 - (1+k)c^2 r^2}};$$

where r is a radius of the side surface of the conical cavity related to the optical axis;
z is a sagitta value of a point of the side surface of the conical cavity at which the radius is r;
c is a curvature coefficient of the side surface of the conical cavity; and
k is a cone coefficient of the side surface of the conical cavity

3. The light device of claim 2, wherein the origin of side surface of the conical cavity is located at a center apex of the side surface of the conical cavity which is located at the optical axis, and the focal length F of the side surface of the conical cavity satisfies a formula:

$$F = \frac{1}{(N-1)c};$$

wherein N is a refractive index of the optical lens, and c is the curvature coefficient of the side surface of the conical cavity, and $-50 < F < -0.5$.

4. The light device of claim 2 or claim 3, wherein $1/c$ is equal to -1.472524, and k is equal to -3.886628.

5. The light device of any preceding claim, wherein the second surface satisfies a formula: $z=\gamma_1 x^2+\gamma_2 x^4+\gamma_3 x^6+\gamma_4 x^8+\gamma_5 \gamma^2 +\gamma_6\gamma^4+\gamma_7\gamma^6+\gamma_8 x^8$, and wherein $\gamma_1$ to $\gamma_8$ are aspheric surface coefficients.

6. The light device of claim 5, wherein $\gamma_1$ and $\gamma_5$ are in the same range, as are $\gamma_2$ and $\gamma_6$.

7. The light device of claim 6, wherein $-0.1 < \gamma_1 < 0.1$ and $-0.01 < \gamma_2 < 0.01$.

8. The light device of one of claims 5 to 7, wherein the origin of the side surface of the conical cavity is located at a center apex of the side surface of the conical cavity which is located at the optical axis, the origin of the second surface is also at the optical axis, and an included angle between the tangent plane of the second surface and passing through the origin of the second surface and the plane perpendicular to the optical axis and passing through the origin of the second surface is θ.

9. The light device of claim 8, wherein $0° < \theta \leqq 10°$.

10. The light device of one of claims 5 to 9, wherein $\gamma_1$ is equal to 1.8422E-03, $\gamma_2$ is equal to 3.4516E-04, $\gamma_3$ is equal to 4.2832E-07, $\gamma_4$ is equal to 1.3530E-09, $\gamma_5$ is equal to -6.7515E-02, $\gamma_6$ is equal to 5.7794E-04, $\gamma_7$ is equal to -1.3900E-05, and $\gamma_8$ is equal to -4.9534E-08.

FIG. 1

EP 2 315 068 A1

FIG. 2

FIG. 3

FIG. 4

FIG. 5

Europäisches
Patentamt

European
Patent Office

Office européen
des brevets

# EUROPEAN SEARCH REPORT

Application Number

EP 10 18 6666

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DE 20 2009 009763 U1 (CREATE ELECTRONIC OPTICAL CO LTD [TW]) 15 October 2009 (2009-10-15) * figures 1-5 * | 1-10 | INV.<br>G02B27/09<br>F21V5/04<br>H01L33/58<br>G02B3/02 |
| X | US 2007/091615 A1 (HSIEH CHI-TANG [TW] ET AL) 26 April 2007 (2007-04-26) * figure 18 * | 1 | |
| X,P | EP 2 175 193 A1 (SHARP KK [JP]) 14 April 2010 (2010-04-14) * paragraph [0030] * | 1 | |
| X | US 2008/203412 A1 (SHYU SAN-WOEI [TW] ET AL) 28 August 2008 (2008-08-28) * figure 10 * | 1 | |

TECHNICAL FIELDS
SEARCHED (IPC)

G02B
H01L
F21V

The present search report has been drawn up for all claims

| Place of search | Date of completion of the search | Examiner |
|---|---|---|
| The Hague | 23 November 2010 | Quertemont, Eric |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 10 18 6666

This annex lists the patent family members relating to the patent documents cited in the above-mentioned European search report.
The members are as contained in the European Patent Office EDP file on
The European Patent Office is in no way liable for these particulars which are merely given for the purpose of information.

23-11-2010

| Patent document cited in search report | Publication date | Patent family member(s) | Publication date |
|---|---|---|---|
| DE 202009009763 U1 | 15-10-2009 | US 2010149801 A1 | 17-06-2010 |
| US 2007091615 A1 | 26-04-2007 | NONE | |
| EP 2175193 A1 | 14-04-2010 | CN 101772670 A<br>JP 4350144 B2<br>JP 2009043628 A<br>WO 2009020214 A1<br>US 2010135028 A1 | 07-07-2010<br>21-10-2009<br>26-02-2009<br>12-02-2009<br>03-06-2010 |
| US 2008203412 A1 | 28-08-2008 | NONE | |

EPO FORM P0459

For more details about this annex : see Official Journal of the European Patent Office, No. 12/82